Europäisches Patentamt

European Patent Office

Office européen des brevets

(19)

(11) Veröffentlichungsnummer: **0 102 041**

**A2**

(12) **EUROPÄISCHE PATENTANMELDUNG**

(21) Anmeldenummer: **83108213.6**

(22) Anmeldetag: **19.08.83**

(51) Int. Cl.³: **H 01 L 23/48**
//H01L23/30

(30) Priorität: **25.08.82 DE 3231557**

(43) Veröffentlichungstag der Anmeldung:
**07.03.84 Patentblatt 84/10**

(84) Benannte Vertragsstaaten:
**AT CH DE FR GB IT LI NL SE**

(71) Anmelder: **SIEMENS AKTIENGESELLSCHAFT**
**Berlin und München Wittelsbacherplatz 2**
**D-8000 München 2(DE)**

(72) Erfinder: **Beer, Gottfried, Ing. grad.**
**Waldstrasse 2**
**D-8411 Etterzhausen(DE)**

(72) Erfinder: **Engl, Alfred, Dr. Dipl.-Chem.**
**Heckenweg 6**
**D-8400 Regensburg(DE)**

(54) **Elektrisches Bauelement mit mindestens einer Anschlussfahne.**

(57) Es wird ein elektrisches Bauelement mit mindestens einer Anschlußfahne (1) beschrieben, von der sich ein erster Teil (2) innerhalb einer Plastikumhüllung (6) befindet und ein zweiter Teil (3) außerhalb der Plastikumhüllung (6) befindet. Der zweite Teil (3) weist mindestens eine Verformung (4) auf, wobei die Anschlußfahne im Bereich der Verformung (4) mindestens eine Verjüngung im Vergleich zum ersten Teil (2) ein und derselben Anschlußfahne aufweist. Die beschriebene Ausführungsform ist anwendbar bei plastikumhüllten elektronischen Bauelementen, insbesondere bei Dioden und Transistoren im SOT 23- oder SOT 143-Gehäusen.

FIG 1

SIEMENS AKTIENGESELLSCHAFT
Berlin und München

Unser Zeichen
VPA 82 P 1704 E

Elektrisches Bauelement mit mindestens einer Anschlußfahne

Die Erfindung betrifft ein elektrisches Bauelement mit mindestens einer Anschlußfahne, von der sich ein erster Teil innerhalb einer Plastikumhüllung und ein zweiter Teil sich außerhalb der Plastikumhüllung befindet. Bei der Montage von plastikumhüllten Halbleiterbauelementen wie Transistoren oder Dioden oder von plastikumhüllten ICs werden die einzelnen Bauelemente häufig auf eine Montageplatte in der Weise aufgebracht, daß sie mittels abgebogener Anschlußfahnen an der Montageplatte z. B. durch Auflöten befestigt werden. Beim Abbiegen der Anschlußfahnen treten häufig so große Druck- und Zugkräfte zwischen den Anschlußfahnen und der Plastikumhüllung auf, daß die Plastikumhüllung im Bereich der Anschlußfahnen durch Risse beschädigt oder zerstört wird. Bei beschädigten Bauelementen führen die Risse in der Plastikumhüllung oftmals zum Halbleiter-Chip hin, so daß ein solches Bauelement nicht mehr hinreichend gegen Feuchte und Korrosionsschäden geschützt ist, was zu erhöhten Ausfallquoten hiernach gefertigter Bauelemente führt. Auf der Innenseite der zu biegenden Anschlußfahne d.h. auf derjenigen Seite der Anschlußfahne die den kleinsten Krümmungsradius bei der Biegung aufweist, können außerdem Teilchen aus dem Plastikverguß (Füllstoffteilchen) in die Oberfläche der Anschlußfahnen gedrückt werden, so daß sich auch in den Anschlußfahnen selbst Rißbildungen entwickeln. Diese Rißbildungen führen zu einem früheren oder späteren Abbrechen der Anschlußfahnen,

Kus 1 Gae / 20.08.1982

insbesondere bei Ultraschallreinigung, und erhöhen somit ebenfalls die Ausfallquote hiernachgefertigter Bauelemente.

Die nachteiligen Wirkungen von Biegekräften bei der Verformung von Anschlußfahnen plastikvergossener Bauelemente lassen sich dadurch verringern, daß das zu verbiegende Anschlußfahnenteil geeignet, beispielsweise mit Schneiden, unterstützt wird. Je kleiner die Abmessungen der zu biegenden Anschlußfahnen sind, desto schwieriger ist es, derartige Biegewerkzeuge mit geeigneten kleinen Toleranzen herzustellen. Der Verschleiß des Biegewerkzeugs führt bei der Bearbeitung von entsprechend kleinen Anschlußfahnen zu zusätzlichen Schwierigkeiten. Die Standzeiten der Werkzeuge sind entsprechend niedrig.

Aufgabe der vorliegenden Erfindung ist daher, ein plastikumhülltes elektrisches Bauelement mit geometrisch sehr kleinen verformten äußeren Anschlußfahnen beispielsweise in einem SOT 23- oder SOT 143- Gehäuse, anzugeben, dessen Zuverlässigkeit durch die verformten Anschlußfahnen nicht beeinträchtigt wird.

Diese Aufgabe wird mittels eines elektrischen Bauelements der eingangs genannten Art dadurch gelöst, daß der zweite Teil 3 mindestens eine Biegung 4 aufweist und die Anschlußfahne 1 im Bereich mindestens einer der Biegungen 4 mindestens eine Verjüngung 5 im Vergleich zum ersten Teil 2 ein- und derselben Anschlußfahne aufweist.

Durch eine geeignete Verjüngung des zweiten Teils der Anschlußfahne gegenüber dem ersten Teil der Anschlußfahne kann bei einer nachfolgenden Biegung der Anschlußfahne am Beginn eines verjüngten Bereichs auch ohne Unterstützung eine Verletzung der Plastikumhüllung vermieden
werden. Auch werden keine Plastikvergußteilchen aus der
Plastikumhüllung in einen verformten Teil der Anschlußfahne eingedrückt, so daß auch die Stabilität der Anschlußfahnen erhalten bleibt. Hiernach gefertigte elektrische Bauelemente haben den Vorteil, eine geringere Ausfallquote aufzuweisen.

Es ist vorteilhaft, daß sich an die Verjüngungen 5 ein
oder mehrere abrupte Übergangsbereiche 28 oder ein oder
mehrere allmählicheÜbergangsbereiche 29 anschließen.

Ist die Anschlußfahne 1 des elektrischen Bauelements
abrupt verjüngt, so ist es vorteilhaft, daß der der Plastikumhüllung 6 unmittelbar benachbarte abrupte Übergangsbereich 28 sich vollkommen außerhalb der Plastikumhüllung 6 befindet. Weist die Anschlußfahne 1 bei der Verjüngung hingegen einen almählichen Übergangsbereich 29
auf, so ist es entweder vorteilhaft, daß der der Plastikumhüllung 6 unmittelbar benachbarte allmählicheÜbergangsbereich 29 sich teilweise oder vollkommen außerhalb der Plastikumhüllung 6 befindet.

Weiterhin ist es vorteilhaft, daß die Anschlußfahne 1 aus
einem Metallblech konstanter Dicke gebildet ist, und daß
die Anschlußfahne 1 sich aus einem im wesentlichen quaderförmigen, unverjüngten Teilstück 31, einem daran angrenzenden abrupten Übergangsbereich 28 oder einem allmählichen Übergangsbereich 29 und einem daran angrenzenden im wesentlichen quaderförmigen verjüngten Teilstück 32 zusammensetzt, wobei die mittels des Übergangsbereichs verjüngte Quaderkante des Teilstücks 32, $b_1$,
und die an den Übergangsbereich angrenzende, zu $b_1$ para-

lele, unverjüngte Quaderkante, $b_2$, in einem durch die folgende Formel wieder gegebenen Verhältnis zueinander stehen:

$$1{,}3 \; b_2 \gtrless 3/2 \; b_1 \frac{\sigma_{pmax}}{\sigma_{emax}}$$

In Hinblick auf die Miniaturisierung von elektronischen Bauelementen ist es vorteilhaft, daß die verformten zweite Teile3 höchstens 1 mm oder 0,7 mm, insbesondere 0,6 mm aus der Plastikumhüllung 6 hervorragen.

Nachfolgend wird die Erfindung anhand der Zeichnung und von Ausführungsbeispielen näher erläutert. Es zeigen:

Fig. 1 ein elektrisches Bauelement mit gebogenen Anschlußfahnen

Fig. 2 eine Anschlußfahne mit abrupt verjüngtem Querschnitt

Fig. 3 eine Anschlußfahne mit allmählich verjüngtemQuerschnitt

Fig. 4 Spannungsverläufe im Inneren der Anschlußfahne und der Plastikumhüllung

Fig. 5 Spannungs-Dehnungs-Diagramm.

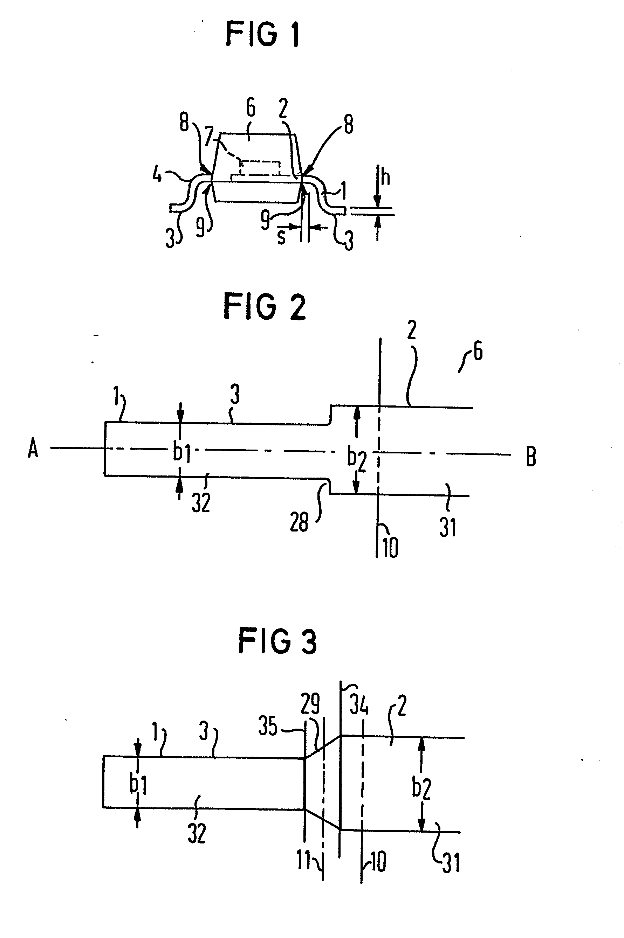

In Fig. 1 wird eine Plastikumhüllung 6 gezeigt, die in ihrem Inneren einen Halbleiter-Chip 7 enthält. Das Bauelement ist mit mindestens einer Anschlußfahne 1 versehen, wobei ein erster Teil 2 der Anschlußfahne sich innerhalb der Plastikumhüllung 6 befindet, während ein zweiter Teil 3 der Anschlußfahne 1 sich außerhalb der Plastikumhüllung 6 befindet. Der zweite Teil 3 ist zweifach gebogen ausgeführt und ragt nach dem Verbiegen in der Projektion auf die Unterlage um 0,4 mm bis 1 mm, insbesondere 0,7 mm, aus der Plastikumhüllung 6 heraus. Die Fertigungstoleranzen der Anschlußfahne 1 betragen 0,2 mm. Die Anschlußfahne 1 ist aus einem Blech konstanter Dicke h gefertigt. Die Dicke h beträgt beispielsweise 0,1 mm und ist mit einer Toleranz von +0,05 mm gefertigt. Bei einem Ausführungsbeispiel nach der Fig. 1 wäre zur Erzeugung der ersten Biegung 4 der Anschlußfahne 1 nach der Plastikumhüllung 6 eine unterstützende Schneide s mit einer Breite von weniger als 0,2 mm erforderlich. Wird die Anschlußfahne 1 ohne eine unterstützende Schneide gebogen, so bildet sich an der Stelle 8 ein Spalt in der Plastikumhüllung 6.Gelegentlich treten durch die Biegung der Anschlußfahne 1 auch Risse in der Plastikumhüllung auf, die von der Stelle 8 seitlich bis zu den Stellen 9 der Plastikumhüllung 6 verlaufen. Anschlußfahnen 1 werden in der Praxis häufig als Teil eines Trägers für das Halbleiterchip 7 eines sogenannten Leadframes, gefertigt. Die Anschlußfahnen 1 können von gewissen Teilen des Leadframes je nach Bedarf, z.B. durch geeigneten Unterteilen, elektrisch isoliert werden.

In Fig. 2 ist eine aus einem Metallblech konstanter Dicke gefertigte Anschlußfahne 1 dargestellt, die einen abrupten Übergangsbereich 28 aufweist mit einer Verjüngung der Breite $b_2$ auf die Breite $b_1$. Ein derart verjüngter äußerer Anschlußteil kann auch ohne Unterstützung so gebogen werden, daß in der Plastikumhüllung 6 keine Risse entstehen. Die Plastikumhüllung 6 reicht bei diesem Ausführungsbeispiel bis zur Begrenzungslinie 10. Ein Teil des unverjüngten Teilstücks 31 ragt um 0,05 mm bis 0,03 mm aus der Plastikumhüllung heraus. Anschließend daran grenzt der abrupte Übergangsbereich 28 und mündet in das verjüngte Teilstück 32.

Fig. 3 zeigt eine Anschlußfahne 1 mit allmählich verjüngtem Querschnitt. Der allmähliche Übergangsbereich 29 kann beliebig gestaltet sein und wird durch die Linien 34, 35 begrenzt. Alle entsprechenden Bezugszeichen aus Fig. 1 und 2 sind in Fig. 3 analog verwendet. Die Plastikumhüllung 6 kann wahlweise bis zur Begrenzungslinie 10 oder, was einem weiteren Ausführungsbeispiel entspricht, auch bis zu der strichpunktierten Begrenzungslinie 11 reichen. Bei dem letztgenannten Ausführungsbeispiel wird ein Teil des allmählich verjüngten Querschnitts der Anschlußfahne 1 von der Plastikumhüllung 6 umschlossen.

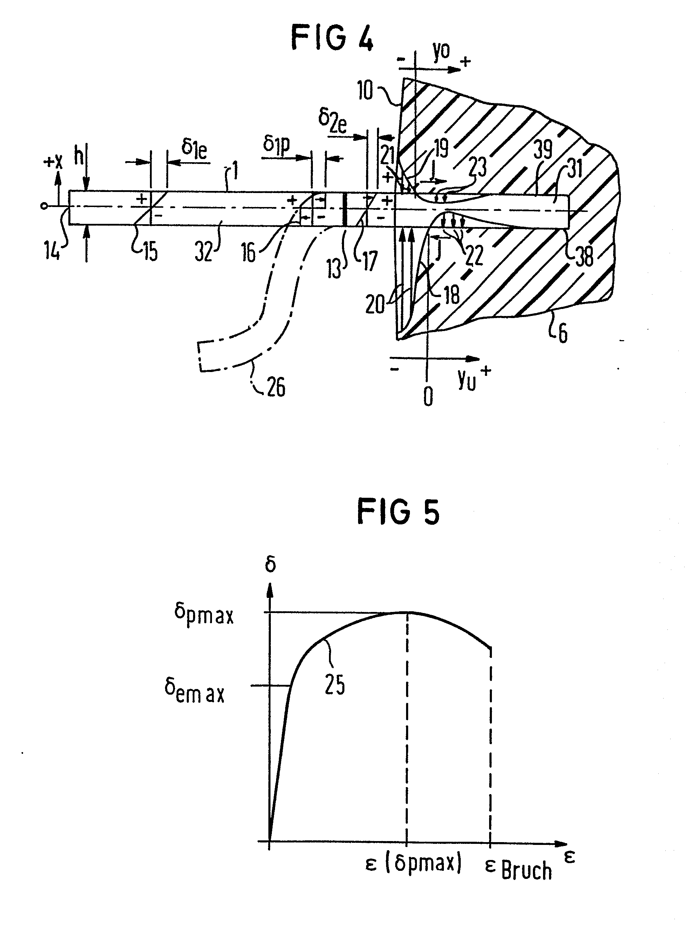

Fig. 4 stellt einen Schnitt durch eine Anschlußfahne 1 und die Plastikumhüllung 6 nach Fig. 2 längs der dort eingetragenen strichpunktierten Linie A-B dar. Die Anschlußfahne 1 weist über die gesamte Länge eine konstante Dicke h auf. Im linken Figurenteil bis zur Trennlinie 13 ist der verjüngte Teil der Anschlußfahne 1 dargestellt. Die Linie 13 markiert den abrupten Übergangsbereich 28 nach Fig. 2. Der Teil der Anschlußfahne 1 rechts von der Trennlinie 13 stellt das unverjüngte Teilstück 31 der Anschlußfahne 1 dar sowie die Plastikumhüllung 6. Durch die Anschlußfahne 1 ist eine gedachte Mittellinie 14 als strichpunktierte Linie eingetragen. Der Abstand x eines Punktes, der oberhalb der Linie 14 liegt, wird positiv gezählt, während der Abstand unterhalb der Linie 14 negativ gezählt wird; was für die nachfolgende Formelableitung von Bedeutung ist. Die Linie 15 stellt den Spannungsverlauf bei elastischer Verformung im verjüngten Teilstück $3^2$ der Anschlußfahne 1, $\sigma'_{1e}$ in Abhängigkeit von x, dar. Da nach dem Hookschen Gesetz die Dehnung proportional zum Biegemoment bzw. proportional zur Zugspannung ist, stellt die Linie 15 eine Gerade dar, wobei sich für positive x-Werte auch positive $\sigma'$-Werte ergeben, angedeutet durch das kleine Pluszeichen oberhalb der strichpunktierten Mittellinie 14, während sich für negative

x-Werte auch negative $\sigma$-Werte ergeben, angedeutet durch eine kleines Minuszeichen unterhalb der Mittellinie 14. Die unterschiedlichen Vorzeichen der $\sigma$-Werte verdeutlichen lediglich die wohlbekannte Dehnung und Stauchung an gegenüberliegenden Oberflächen beim Biegen eines Bleches. Mit der Treppenlinie 16 wird der theoretische Spannungsverlauf bei plastischer Verformung $\sigma_{1p}$ in Abhängigkeit von x dargestellt. An der Stelle x = 0 weist die zugehörige Funktion eine Sprungstelle auf; diese Tatsache wird auch in den nachfolgenden Gleichungen (VI) und (VII) zum Ausdruck gebracht. Rechts neben der Trennlinie 13, ist der Spannungsverlauf bei elastischer Verformung im unverjüngten Teilstück 31, $\sigma_{2e}$, durch die Linie 17 dargestellt. 17 stellt ebenfalls wie 15 eine Gerade dar, die Beträge der zu gleichen x-Werten gehörenden $\sigma$-Werte sind jedoch kleiner im Fall der Linie 17 verglichen mit denen der Linie 15, was der Tatsache entspricht, daß die Spannung im nicht verjüngten Teil kleiner ist als die entsprechende Spannung im verjüngten Teil. Die Linie 10 stellt wie in Fig. 2 die Begrenzungslinie zwischen Plastikumhüllung 6 und dem Raum außerhalb der Plastikumhüllung dar, und ist wegen der Entformungsschrägen keine durchgehende Gerade. Die Richtung $y_u$ gibt den Abstand eines beliebigen Punktes an der unteren Grenzfläche Leadframe-Plastikumhüllung, dargestellt durch die Porjektionslinie 38, zum neutralen Punkt an. Der neutrale Punkt ist der jenige Punkt, bei dem die Druck- bzw. Zugspannung Null ist. Für $y_o$ gilt Analoges für die obere Grenzfläche Leadframe-Plastikumhüllung und die Projektionslinie 39. Die Linie 18 gibt den qualitativen Spannungsverlauf an der unteren Grenzfläche Leadframe-Plastikumhüllung an, während die Linie 19 diesen Spannungsverlauf an der entsprechenden oberen Grenzfläche darstellt. Die Ausdrücke "unten" bzw. "oben" beziehen sich auf die Lage der Fig. 4 innerhalb der Zeichenebene und im Bezug zur Mittellinie 14.

Der strichpunktierte Teil 26 gibt an in welcher Richtung das verjüngte Teilstück 32 gebogen wird.

Wie man sieht sind die Spannungen an der Begrenzungslinie 10 der Kunststoffumhüllung 6 am größten und dürfen hier die zulässigen Werte nicht überschreiten. Da der Kunststoff höhere Druck- als Zugspannungen aufnehmen kann, sind die Pfeile 20 länger dargestellt als Pfeile 21. Im Bereich eines Spaltes hätte die Zugspannung, dargestellt durch die Pfeile 21 den Wert 0, da der Spalt keine Spannung übertragen kann.

Das Moment, hervorgerufen durch diese Spannungen muß unter Vernachlässigung von $\mathcal{T}$ gleich dem Biegemoment sein, das zur Verformung einer Anschlußfahne 1 bzw. des Leadframes aufgebracht werden muß:

$$(\text{XIII}) \quad M_B = b_2 \int \sigma(y_u)\, y_u\, dy_u + b_2 \int \sigma(y_o)\, y_o\, dy_o$$

Da sich die Kräfte auf dem erfindungsgemäß größeren $b_2$ abstützen, resultieren zusätzlich zur Verhinderung von plastischen Verformungen in dem Kunststoffbereich an dem Teil der Kunststoffgrenzfläche, der in der Projektion durch die Begrenzungslinie 10 dargestellt wird, niedrigere Spannungen. Bezüglich der Bedeutung der verwendeten Buchstaben wird auf die Seiten 57 , 59, verwiesen.

Bei allen dargestellten Spannungsverläufen, sowohl in der Anschlußfahne wie auch in der Plastikumhüllung wurden Querkräfte vernachlässigt, was im Anbetracht der Größenverhältnisse zwischen Zug- und Druckspannungen einerseits und Scherspannungen andererseits durchaus vertretbar ist.

Mit der folgenden Berechnung wird ermittelt, wie stark der Querschnitt der Anschlußfahne 1 verjüngt werden muß, um auch bei einer nichtunterstützten Biegung der Anschlußfahne eine Rißbildung in der Plastikumhüllung 6 zu vermeiden.

Die Berechnung erfolgt für eine Anschlußfahne, ie aus einem Metallblech konstanter Dicke gestanzt ist. In den nachfolgenden Formelableitungen stehen folgende Symbole für die nachgenannten physikalischen Größen:

$\sigma$ : Zug- bzw. Druckspannung

$\tau$ : Schubspannung

$\varepsilon$ : Dehnung

$\varphi$ : Scherwinkel

$M_B$ : Biegemoment

$A$ : Fläche

$h$ : Dicke der Anschlußfahne

$x$ : Variable gemessen in Richtung der Dicke h

$b_i$ : Breit der Anschlußfahne an der Stelle i

Außerdem werden die folgenden Inizes im nachgenannten Sinne verwendet:

p : plastische Verformung

e : elastische Verformung

1 : verjüngte Querschnittstelle

2 : nicht verjüngte Querschnittstelle

Aufgrund vorliegender Materialdaten ist es bekannt, daß Rißbildungen in einer Plastikumhüllung stets nur dann auftreten, wenn die an den Metallteilen angreifenden Kräfte plastische Verformungen in denjenigen Metallteilen bewirken, die von Plastik umhüllt sind. Spannungen, die kleiner sind, das Metall im plastikumhüllten Bereich somit nur elastisch verformen, bewirken auch bei der Plastikumhüllung nur eine elastische Verformung und somit keine Spaltbildung. Bei der nachfolgenden Berechnung braucht deshalb nur ermittelt zu werden, wie stark eine Anschlußfahne verjüngt werden muß, damit am verjüngten Teil angreifende Biegekräfte den verjüngten Teil plastisch verformen, während sie den nicht verjüngten Teil lediglich elastisch verformen.

Die Spannung für die elastische Verformung beträgt nach dem Hookschen Gesetz:

$$(I) \qquad \sigma_i(x) = \left(\frac{2\sigma_{ie}}{h}\right) \cdot x$$

$$(II) \qquad M_{Be} = \int_A \sigma(A) \cdot x(A)\, dA$$

dabei ist:

$$(III) \qquad dA = b_i\, dx$$

eingesetzt in Gleichung II ergibt sich:

$$(IV) \qquad M_{Be} = \int_{-\frac{h}{2}}^{+\frac{h}{2}} \sigma(x) \cdot x \cdot b_i\, dx$$

$$(V) \qquad M_{Be} = \frac{h^2}{6} b_i\, \sigma_{ie}$$

Bei der plastischen Verformung gilt für den Spannungsverlauf Gleichung I nicht mehr sondern:

$$(VI) \qquad \sigma(x) = \sigma_p \qquad \text{für } x > 0$$

(VII) $\qquad \sigma(x) = -\sigma_p \quad \text{für } x < 0$

Setzt man diese $\sigma$-Werte in Gleichung II ein und integriert damit Gleichung II so ergibt sich:

(VIII) $\qquad M_{Bpi} = b_i \cdot \sigma_{ip} \dfrac{h^2}{4}$

Zur Verdeutlichung der weiteren Formelableitung und dort getroffener Annahmen wird Fig. 5 betrachtet.
Fig. 5 zeigt ein Spannung-Dehnungsdiagramm wie es qualitativ z.B. für alle Metalle zutrifft. Die Spannung $\sigma$ wächst zunächst linear mit der Dehnung $\varepsilon$ gemäß dem Hookschen Gesetz an, was im ersten Teil der Linie 25 zeichnerisch dargestellt ist. Nach Erreichen des maximalen Spannungswertes für die elastische Verformung ($\sigma_{emax}$) bewirken weiter ansteigende Spannungen plastische Verformungen eines betrachteten Versuchstücks mit zugehörigen größeren Denungen $\varepsilon$. Nach dem Erreichen einer maximalen Spannung bei der plastischen Verformung ($\sigma_{pmax}$), werden durch die Anwendung kleinerer $\sigma$-Werte als $\sigma_{pmax}$ größere Dehnungen erreicht als bei dem Wert $\sigma_{pmax}$. Bei weiterer Spannungeinwirkung auf ein Versuchstück bricht dieses jedoch bei einem $\varepsilon$-Wert $\varepsilon = \varepsilon$-Bruch entzwei. Dort endet spontan die Spannungs-Dehnungskurve.

Nach den anfänglich begründeten Bedingungen soll der nicht verjüngte Teil der Anschlußfahne lediglich elastisch verformt werden, d.h. es soll gelten:

(IX) $\qquad \sigma_2 \leq \sigma_{emax}$

Um die Rechnung zu vereinfachen, wird angenommen:

(X) $\qquad \sigma_{p_1} = \sigma_{pmax}$

was den für die Spaltbildung ungünstigsten Fall beschreibt. Aus den Gleichungen (V), (VIII), (IX) und (X) ergibt sich:

$$(XI) \qquad b_2 \geq \frac{3}{2} b_1 \frac{\sigma_{pmax}}{\sigma_{emax}}$$

Die Berechnung von $b_2$ erfolgt unter der Annahme ungünstigster Bedingungen wie rechteckiger Spannunsverlauf (Gleichungen VI, VII) und überschreiten von $\mathcal{E}(\sigma_{pmax})$.

In der Praxis treffen diese Bedingungen gewöhnlich nicht alle zu. Bei Erprobungen hat sich gezeigt, daß $b_2$ auch um 30% größer sein kann als der nach der Formel (XI) berechnete Wert für $b_2$. Es ergibt sich somit die empirische Formel:

$$(XII) \qquad 1{,}3\, b_2 \geq \frac{3}{2} b_1 \frac{\sigma_{pmax}}{\sigma_{emax}}$$

Das Verhältnis $b_2/b_1$ ist somit abhängig von Verhältnis der maximal zulässigen Zug- bzw. Druckspannung bei plastischer Verformung der entsprechenden Zug- und Druckspannung bei elastischer Verformung.

Praktisch jedes mit Plastik umhüllte elektrische Bauelement läßt sich als erfindungsgemäßes Bauelement gestalten. Insbesondere eignen sich hierfür mit Plastik umhüllte elektronische Bauelemente wie Dioden, Transistoren, vorzugsweise in SOT 23- oder in SOT 143-Gehäusen, oder auch IC's.

Patentansprüche

1. Elektrisches Bauelement mit mindestens einer Anschlußfahne, von der sich ein erster Teil innerhalb einer Plastikumhüllung und ein zweiter Teil sich außerhalb der Plastikumhüllung befindet, d a d u r c h   g e k e n n - z e i c h n e t , daß der zweite Teil (3) mindestens eine Biegung (4) aufweist und die Anschlußfahne (1) im Bereich mindestens einer der Biegungen (4) mindestens eine Verjüngung (5) im Vergleich zum ersten Teil (2) ein- und derselben Anschlußfahne aufweist.

2. Elektrisches Bauelement nach Anspruch 1, d a d u r c h g e k e n n z e i c h n e t , daß sich an die Verjüngungen (5) ein oder mehrere abrupte Übergangsbereiche (28) oder ein oder mehrere allmählicheÜbergangsbereiche 29 anschließen.

3. Elektrisches Bauelement nach Anspruch 2, d a d u r c h g e k e n n z e i c h n e t , daß der der Plastikumhül- lung (6) unmittelbar benachbarte abrupte Übergangsbereich (28) sich vollkommen außerhalb der Plastikumhüllung (6) befindet.

4. Elektrisches Bauelement nach Anspruch 2, d a d u r c h g e k e n n z e i c h n e t , daß der der Plastikumhül- lung.(6) unmittelbar benachbarte allmählicheÜbergangs- bereich (29) sich teilweise oder vollkommen außerhalb der Plastikumhüllung (6) befindet.

5. Elektrisches Bauelement nach mindestens einem der An- sprüche 1 bis 4, d a d u r c h   g e k e n n z e i c h - n e t , daß die Anschlußfahne (1) aus einem Metallblech konstanter Dicke gebildet ist, und daß die Anschlußfahne (1) sich aus einem im wesentlichen quaderförmigen, unverjüngten Teilstück (31), einem daran angrenzenden abrupten Übergangsbereich (28) oder einem allmählichenÜbergangsbereich (29) und einem daran angrenzenden im wesentlichen quaderförmigen verjüngten Teilstück (32) zusammensetzt, wobei die mittels des Übergangsbereichs verjüngte Quaderkante des Teilstücks (32), $b_1$, und die an den Übergangsbereich angrenzende, zu $b_1$ parallele, unverjüngte Quaderkante, $b_2$, in einem durch die folgende Formel wieder gegebenen Verhältnis zueinander stehen:

$$1,3 \; b_2 \geqslant 3/2 \; b_1 \; \frac{\sigma_{pmax}}{\sigma_{emax}}$$

FIG 1

FIG 2

FIG 3

# FIG 4

# FIG 5